# EUROPEAN PATENT APPLICATION

(11) **EP 4 580 382 A1**
(43) Date of publication of application: **02.07.2025**
(21) Application number: 24216851.6
(22) Date of filing: 02.12.2024
(51) Int. Cl.: H10N 30/076, H10N 30/00, H10N 30/853, H10N 39/00

(54) **DEVICE INCLUDING PIEZOELECTRIC ELEMENT AND METHOD FOR MANUFACTURING THE DEVICE**

(30) Priority: 27.12.2023 JP 2023220952
(71) Applicant: Sumitomo Chemical Company, Limited, Tokyo 103-6020 (JP)
(72) Inventor: TANAKA, Yasunori, Hitachi-shi, Ibaraki, 319-1418 (JP); SHIBATA, Kenji, Hitachi-shi, Ibaraki, 319-1418 (JP); KURODA, Toshiaki, Hitachi-shi, Ibaraki, 319-1418 (JP); WATANABE, Kazutoshi, Hitachi-shi, Ibaraki, 319-1418 (JP)
(74) Representative: Vossius & Partner Patentanwälte Rechtsanwälte mbB

(57) **Abstract**

There is provided a device including: a semiconductor element (30); and a piezoelectric element (20) having a piezoelectric film (3) composed of alkali niobium oxide containing potassium, sodium, niobium, and oxygen, wherein the semiconductor element and the piezoelectric element are formed on the same substrate (1).

## Description

### Technical Field

The present disclosure relates to a device including a piezoelectric element and a method for manufacturing the device.

### Description of Related Art

A piezoelectric substance is widely used in a functional electronic component such as a sensor and an actuator. Lead-based materials, particularly PZT-based ferroelectrics represented by a composition formula Pb(Zr₁₋ₓTiₓ)O₃, are widely used as the piezoelectric substance. Since the PZT-based piezoelectric materials contain lead, they are undesirable from a viewpoint of preventing pollution. Therefore, a piezoelectric material containing potassium, sodium, niobium, and oxygen has been proposed as a piezoelectric material not containing lead, and a piezoelectric element having a piezoelectric film (hereinafter, a KNN film) deposited using such a piezoelectric material has been proposed. (see, for example, Patent documents 1 and 2).

### Prior art document

### Patent document

[Patent Document 1] JP 2007-184513 A
[Patent Document 2] JP 2008-159807 A

### Summary of the invention

### Problem to be solved by the invention

For example, there is a case where it is required to form a piezoelectric element having the above-described KNN film on a substrate on which a semiconductor element is formed. In this case, it is sometimes required to reduce the thermal history of the semiconductor element. For this reason, when depositing the KNN film on the substrate on which the semiconductor element is formed, it is sometimes required to deposit the KNN film at a low temperature. However, when the KNN film is deposited at a low temperature, piezoelectric properties may be degraded. Therefore, it is sometimes difficult to form the piezoelectric element having the KNN film on the substrate on which the semiconductor element is formed.

An object of the present disclosure is to provide a device in which a semiconductor element and a piezoelectric element having a KNN film are formed on the same substrate.

### Means for solving the problem

According to one embodiment of the present disclosure, there is provided a device or a stacked substrate including:
a semiconductor element; and
a piezoelectric element having a piezoelectric film composed of alkali niobium oxide containing potassium, sodium, niobium, and oxygen,
wherein the semiconductor element and the piezoelectric element are formed on the same substrate.

According to another embodiment of the present disclosure, there is provided a method for manufacturing a device, the method including:
preparing a substrate on which a semiconductor element is formed; and
forming a piezoelectric element on the substrate,
wherein the forming the piezoelectric element includes depositing a piezoelectric film composed of alkali niobium oxide containing potassium, sodium, niobium, and oxygen on the substrate under conditions of a depositing temperature of 400 °C or more and less than 500 °C, an oxygen partial pressure of 0.0025 Pa or more and less than 0.01 Pa, and an atmospheric pressure of 0.03 Pa or more and less than 0.1 Pa.

### Advantage of the invention

According to the present disclosure, there is provided a device in which a semiconductor element and a piezoelectric element having a KNN film are formed on the same substrate.

### Brief description of the drawings

FIG. 1 is a view showing an example of a cross-sectional structure of a device according to one embodiment of the present disclosure.
FIG. 2 is a view showing an example of a cross-sectional structure of a piezoelectric stack according to one embodiment of the present disclosure.
FIG. 3 is a view showing a variation (modified example) of a cross-sectional structure of a device according to one embodiment of the present disclosure.

### Detailed description of the invention

### <One embodiment of the present disclosure>

Hereinafter, one embodiment of the present disclosure will be described with reference to the drawings.

### (1) Configuration of a device having a piezoelectric element

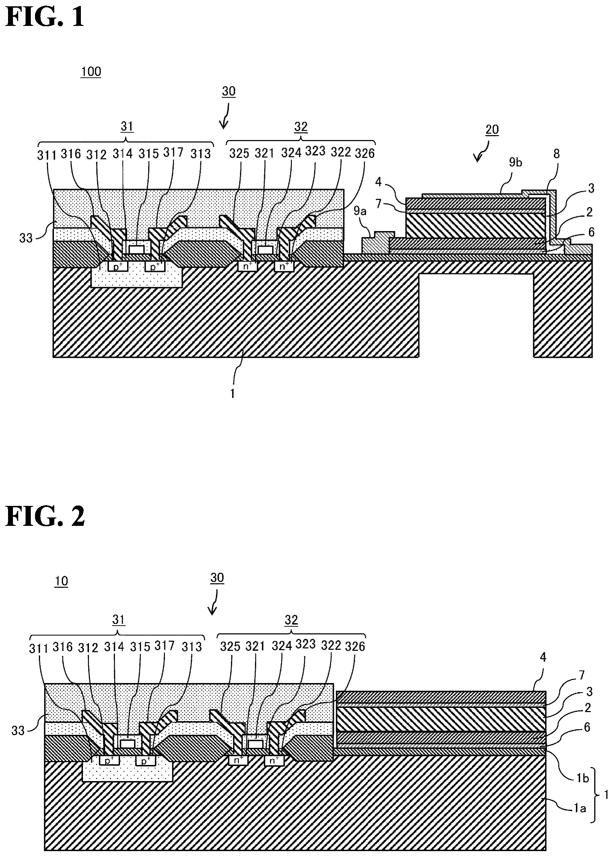

FIG. 1 shows a schematic view of a device 100 having a piezoelectric element according to this embodiment. The device 100 includes a semiconductor element 30 and a piezoelectric element (element having a piezoelectric film) 20. Further, in the device 100, the semiconductor element 30 and the piezoelectric element 20 are formed on the same substrate 1.

The device 100 is obtained by processing a stacked substrate having a piezoelectric film (a stack having a piezoelectric film (piezoelectric stack)) 10 (hereinafter also referred to as a stack 10). FIG. 2 shows a schematic view of the stack 10 according to this embodiment. As shown in FIG. 2, the stack 10 includes a substrate 1, a bottom electrode film 2 deposited on the substrate 1, a piezoelectric film (piezoelectric thin film) 3 deposited on the bottom electrode film 2, and a top electrode film 4 deposited on the piezoelectric film 3. The film obtained by "deposition" in this disclosure is a film directly deposited on the substrate 1, and does not include a film attached (bonded) to the substrate 1.

As the substrate 1, for example, a p-type single crystal silicon (Si) substrate 1a can be used. The thickness of the substrate 1 can be, for example, 300 µm or more and 1000 µm or less.

The semiconductor element 30 is formed on one of the two main surfaces (top surface) of the substrate 1. The semiconductor element 30 has, for example, a p-type MOSFET 31 and an n-type MOSFET 32, and has a complementary metal oxide semiconductor (CMOS) structure in which these elements function complementarily. The p-type MOSFET 31 includes an n-well 311 fabricated in the substrate 1, a p-type source region 312 and a p-type drain region 313 spaced apart from each other within the n-well 311, a gate insulating film 314, a gate electrode 315 formed on the gate insulating film 314, a source electrode 316 electrically connected to the p-type source region 312, and a drain electrode 317 electrically connected to the p-type drain region 313. Also, the n-type MOSFET 32 includes an n-type source region 321 and an n-type drain region 322 spaced apart from each other in the substrate 1, a gate insulating film 323, a gate electrode 324 formed on the gate insulating film 323, and a source electrode 325 electrically connected to the n-type source region 321, and a drain electrode 326 electrically connected to the n-type drain region 322. The n-well 311, the n-type source region 321, and the n-type drain region 322 are each a region formed on one of the two main surfaces of the substrate 1 by thermal diffusion, etc., of n-type dopants. The p-type source region 312 and the p-type drain region 313 are each formed on the surface of the n-well 311 by thermal diffusion, etc., of the p-type dopants.

A protective film 33 such as an oxide film or a nitride film that protects the semiconductor element 30 may be further formed on the substrate 1. It can be considered that the protective film 33 is included in the semiconductor element 30.

On the surface of the substrate 1 on which the semiconductor element 30 is formed (hereinafter also referred to as a "top surface of the substrate 1"), a surface oxide film (SiO₂ film) 1b such as a thermal oxide film or a CVD (Chemical Vapor Deposition) oxide film may be formed except in the area where the semiconductor element 30 is formed. That is, the substrate 1 may be a p-type single crystal Si substrate 1a having a surface oxide film 1b. The thickness of the surface oxide film 1b can be, for example, 1 nm or more and 4000 nm or less. The substrate 1 may have an insulating film composed of an insulating material other than SiO₂, instead of the surface oxide film 1b. Further, the substrate 1 does not need to have the surface oxide film 1b or the insulating film.

The bottom electrode film 2 is formed on the top surface of the substrate 1 at a location different from where the semiconductor element 30 is formed (on the surface oxide film 1b or the insulating film if the substrate 1 has the surface oxide film 1b or the insulating film, etc.). The bottom electrode film 2 may be formed using, for example, platinum (Pt). The bottom electrode film 2 is a polycrystalline film. Hereinafter, the polycrystalline film deposited using Pt is also referred to as a Pt film. It is preferable that the (111) of the Pt film is parallel to the main surface of the substrate 1 (including the case where the (111) is inclined at an angle of ±5° or less with respect to the main surface of the substrate 1), that is, the Pt film is oriented in a

(111) direction. The Pt film being oriented in the (111) direction means that no peaks other than those resulting from the (111) are observed in an X-ray diffraction pattern obtained by X-ray diffraction (XRD) measurement for the surface of the piezoelectric film 3. Thus, it is preferable that the main surface of the bottom electrode film 2 (the surface serving as the base for the piezoelectric film 3) is composed of Pt(111). The bottom electrode film 2 can be deposited by a technique such as a sputtering method or an evaporation method. As a material for the bottom electrode film 2, other than Pt, various metals such as gold (Au), ruthenium (Ru), or iridium (Ir), alloys containing these as main components, or metal oxides such as strontium ruthenium oxide (SrRuO₃, abbreviated as SRO) or lanthanum nickel oxide (LaNiOs, abbreviated as LNO) can also be used. When the bottom electrode film 2 is deposited using a metal oxide, it is preferable that the crystals constituting the bottom electrode film 2 are preferentially oriented in a (001) direction with respect to the surface of the substrate 1. The bottom electrode film 2 may be a single layer film formed using any of the above metals, alloys mainly composed of any of the above metals, or metal oxides, etc. The bottom electrode film 2 may be a stack of the Pt film and a film mainly composed of SRO provided on the Pt film, or a stack of the Pt film and a film mainly composed of LNO provided on the Pt film, etc. The thickness of the bottom electrode film 2 (when the bottom electrode film 2 is a stack, the total thickness of each layer) may be, for example, 100 nm or more and 400 nm or less.

An adhesive layer 6 may be provided between the substrate 1 and the bottom electrode film 2 in order to improve adhesion therebetween. The adhesive layer 6 may be, for example, a layer (hereinafter also referred to as a "ZnO layer") containing zinc (Zn) and oxygen (O) as main components. The ZnO layer can be formed using, for example, zinc oxide. The composition ratio of Zn and O constituting the ZnO layer preferably satisfies a relationship Zn:O = 1:1, but is not limited thereto and some variation is permissible. The ZnO layer is a polycrystalline layer. It is preferable that the (0001) of the ZnO layer is parallel to the main surface of the substrate 1 (including the case where the (0001) is inclined at an angle of ±5° or less with respect to the main surface of the substrate 1), that is, the ZnO layer is oriented in the (0001) direction. The ZnO layer being oriented in the (0001) means that in the X-ray diffraction pattern obtained by XRD measurement for the surface of the piezoelectric film 3, the intensity of the peak resulting from the (0002) is high. Thus, the main surface of the ZnO layer (the surface serving as the base for the bottom electrode film 2) is preferably composed of ZnO(0001). The ZnO layer can be deposited by a technique such as a sputtering method or an evaporation method. The thickness of the ZnO layer may be, for example, 1 nm or more and 200 nm or less, preferably 10 nm or more and 50 nm or less. As the adhesive layer 6, for example, a layer mainly composed of titanium (Ti), tantalum (Ta), titanium oxide (TiO₂), nickel (Ni), ruthenium oxide (RuO₂), iridium oxide (IrO₂), etc., may be provided. Such an adhesive layer 6 may also be deposited by a technique such as a sputtering method or an evaporation method, and the thickness of the adhesive layer 6 may be, for example, 1 nm or more and 200 nm or less, preferably 10 nm or more and 50 nm or less. In this specification, the adhesive layer 6 provided between the substrate 1 and the bottom electrode film 2 may be referred to as a bottom adhesive layer 6.

The piezoelectric film 3 is a film formed from, for example, an alkali niobium oxide containing potassium (K), sodium (Na), niobium (Nb), and oxygen (O). That is, the piezoelectric film 3 is a film mainly composed of alkali niobium oxide containing K, Na, Nb, and O. The piezoelectric film 3 may be formed using an alkali niobium oxide represented by a composition formula (K₁₋ₓNaₓ)NbO₃, that is, potassium sodium niobium oxide (KNN). The coefficient x [= Na/(K+Na)] in the above composition formula may be within a range of 0 < x < 1, preferably 0.4 ≤ x ≤ 0.8. The piezoelectric film 3 is a KNN polycrystalline film (hereinafter also referred to as a KNN film 3). Further, the crystal structure of KNN is a perovskite structure. That is, the KNN film 3 has the perovskite structure. It is preferable that more than half of the crystals in the crystal group constituting the KNN film 3 have a columnar structure. In this specification, the crystal system of KNN is considered to be a tetragonal system. The KNN film 3 may be deposited by a sputtering method. The thickness of the KNN film 3 may be, for example, 0.5 µm or more and 5 µm or less, preferably 1 µm or more and 3 µm or less.

The crystals constituting the KNN film 3 are preferentially oriented in the (001) direction with respect to the main surface of the substrate 1 (Si substrate 1a when the substrate 1 is, for example, a Si substrate 1a having a surface oxide film 1b or an insulating film, etc.). That is, the main surface of the KNN film 3 (the surface serving as the base for the top electrode film 4) is mainly composed of KNN(001). For example, by directly depositing the KNN film 3 on the Pt film (bottom electrode film 2) whose main surface is mainly composed of Pt(111), the KNN film 3 whose main surface is mainly composed of KNN(001) can be obtained. In this specification, the crystals constituting the KNN film 3 being oriented in the (001) direction means that the (001) of the crystals constituting the KNN film 3 is parallel or approximately parallel to the main surface of the substrate 1. Further, the crystals constituting the KNN film 3 being preferentially oriented in the (001) direction means that there are many crystals in which the (001) is parallel or approximately parallel to the main surface of the substrate 1.

Further, the alkali niobium oxide constituting the KNN film 3 may further contain at least one element (dopant) selected from the group consisting of lithium (Li), magnesium (Mg), calcium (Ca), strontium (Sr), barium (Ba), bismuth (Bi), antimony (Sb), vanadium (V), indium (In), tantalum (Ta), molybdenum (Mo), tungsten (W), chromium (Cr), Ti, zirconium (Zr), hafnium (Hf), scandium (Sc), yttrium (Y), lanthanum (La), cerium (Ce), praseodymium (Pr), neodymium (Nd), samarium (Sm), europium (Eu), gadolinium (Gd), terbium (Tb), dysprosium (Dy), holmium (Ho), erbium (Er), thulium (Tm), ytterbium (Yb), lutetium (Lu), copper (Cu), zinc (Zn), silver (Ag), manganese (Mn), iron (Fe), cobalt (Co), Ni, aluminum (Al), Si, germanium (Ge), tin (Sn), and gallium (Ga). The concentration of these elements in the alkali niobium oxide can be, for example, 5 at% or less (when a plurality of the above elements are contained, the total concentration is 5 at% or less).

The top electrode film 4 is mainly composed of various metals such as Pt, Au, Al, Cu, etc., or alloys thereof. The top electrode film 4 can be deposited by a technique such as a sputtering method, an evaporation method, a plating method, a metal paste method. The top electrode film 4 does not have a large effect on the crystal structure of the KNN film 3 unlike the bottom electrode film 2. Therefore, the material, crystal structure, and deposition technique of the top electrode film 4 are not particularly limited. An adhesive layer 7 mainly composed of, for example, RuO₂, IrO₂, Ti, Ta, TiO₂, Ni, etc., may be provided between the KNN film 3 and the top electrode film 4 in order to improve adhesion therebetween. The thickness of the top electrode film 4 may be, for example, 50 nm or more and 5000 nm or less, preferably 50 nm or more and 300 nm or less. When the adhesive layer 7 is provided, the thickness of the adhesive layer 7 may be, for example, 1 nm or more and 200 nm or less, preferably 5 nm or more and 50 nm or less. In this specification, the adhesive layer 7 provided between the KNN film 3 and the top electrode film 4 may be referred to as a top adhesive layer 7.

As described above, the device 100 including the semiconductor element 30 and the piezoelectric element 20 is obtained by processing the stack 10. As shown in FIG. 1, the piezoelectric element 20 is configured to include the bottom electrode film 2, the KNN film 3, and the top electrode film 4. It can be considered that the substrate 1 is included in the piezoelectric element 20. Further, as described above, the bottom electrode film 2 is formed at a location on the surface of the substrate 1 on which the semiconductor element 30 is formed, which is different from the location where the semiconductor element 30 is formed. As a result, the piezoelectric element 20 is formed on the surface of the substrate 1 at a location different from the location where the semiconductor element 30 is formed.

Also, the piezoelectric element 20 further includes an insulating film 8 and metal wirings 9a and 9b.

The metal wiring 9a is provided so as to be connected (in contact) with the bottom electrode film 2 but not connected (in contact) with the top electrode film 4. Further, the metal wiring 9b is provided so as to be connected to the top electrode film 4 and not connected to the bottom electrode film 2. The metal wirings 9a and 9b each can be formed using various metals such as Au, Al, Ti, Cr, etc., or alloys mainly composed of these metals. The metal wirings 9a and 9b may be a single layer film or a stack in which multiple layers are stacked. The metal wirings 9a and 9b can be formed by a technique such as a sputtering method, an evaporation method, a plating method, or a metal paste method.

The insulating film 8 is provided to insulate the metal wiring 9b from the bottom electrode film 2. For example, the insulating film 8 is provided extending from the top electrode film 4 to the substrate 1 so as to cover a part of the side surface of the KNN film 3. The insulating film 8 can be formed using oxide, etc., such as silicon oxide (SiO₂), aluminum oxide (Al₂O₃), or tantalum oxide (Ta₂O₅). The insulating film 8 may be a single layer film or a stack in which multiple layers are stacked. The insulating film 8 can be formed by a technique such as a CVD method or a sputtering method.

In the device 100, the piezoelectric element 20 and the semiconductor element 30 are electrically connected via metal wirings 9a and 9b, and the piezoelectric element 20 is controlled by the semiconductor element 30.

For example, when the piezoelectric element 20 functions as an actuator, the (deforming) action of the piezoelectric element 20 is controlled by the semiconductor element 30. Specifically, application of voltage between the bottom electrode film 2 and the top electrode film 4 by the semiconductor element 30 enables to deform the KNN film 3 of the piezoelectric element 20. Due to such a deforming action of the piezoelectric element 20 (KNN film 3), various structures connected to the device 100 can be operated. In this case, for example, the device 100 can be applied to heads for inkjet printers, MEMS mirrors for scanners, and vibrators for ultrasonic generators, etc.

For example, when the piezoelectric element 20 functions as a sensor, the signal detected by the piezoelectric element 20 is processed by the semiconductor element 30. For example, when the KNN film 3 of the piezoelectric element 20 is deformed in accordance with a change in some physical quantity, voltage is generated between the bottom electrode film 2 and the top electrode film 4 due to the deformation. This voltage is detected as a signal by the piezoelectric element 20, and the signal detected by the piezoelectric element 20 is processed by the semiconductor element 30. Thereby, the magnitude of the physical quantity applied to the KNN film 3 can be measured. In this case, for example, the device 100 can be applied to an angular velocity sensor, an ultrasonic sensor, a pressure sensor, an acceleration sensor, etc.

Further, for example, when the piezoelectric element 20 functions as a harvester, the semiconductor element 30 is operated by the electrical energy generated by the piezoelectric element 20.

Although details will be described later, this embodiment shows that in the process of fabricating the device 100 (the stack 10), the KNN film 3 is deposited under conditions of low temperature, high oxygen partial pressure, and low atmospheric pressure. Thereby, the stack 10 and therefore the device 100 in this embodiment can have at least one of Feature 1, Feature 2, and Feature 3 described below. Various features that the stack 10 and therefore the device 100 of this embodiment may have will be described below.

### (Feature 1)

During the deposition of the KNN film 3, alkali metals (potassium atoms, sodium atoms) may diffuse and reach the substrate 1 through the bottom electrode film 2 (and the bottom adhesive layer 6). When the alkali metals diffuse and reach the substrate 1, the adhesion between the substrate 1 and the bottom electrode film 2 (or a bottom adhesive layer 6, if present) may decrease. As a result, when an excessively external force is repeatedly applied to the periphery (peripheral members) of the bottom electrode film 2 due to repeated large deformation of the KNN film 3 during drive of the device 100 (the piezoelectric element 20), peeling of the bottom electrode film 2 and therefore the KNN film 3 from the substrate 1 may occur.

To cope with such a problem, in this embodiment, the KNN film 3 is deposited at a low temperature in the process of fabricating the device 100. This successfully suppresses the diffusion of alkali metals to the substrate 1 and reaching the substrate 1. Specifically, the device 100 in this embodiment has a feature (Feature 1) such that analysis for the surface region of the substrate by secondary ion mass spectrometry (SIMS) reveals that a potassium concentration (K concentration) is 5E15 cm⁻³ or less and a sodium concentration (Na concentration) is 5E15 cm⁻³ or less.

Thus, by depositing the KNN film 3 at a low temperature, the diffusion of alkali metals to the substrate 1 and reaching the substrate 1 can be suppressed, and the device 100 having low K and Na concentrations in the surface region of the substrate 1 can be obtained. This is a novel knowledge that was first found as a result of extensive research by the present inventors.

In this embodiment, the "surface region of the substrate 1" refers to a region extending from the interface between the piezoelectric element 20 and substrate 1 (or, if substrate 1 has a surface oxide film 1b, from the interface between the piezoelectric element 20 and surface oxide film 1b) to a depth of 1 µm toward the rear surface of substrate 1. In this specification, the "rear surface of the substrate 1" refers to the surface opposite to the surface of the substrate 1 (the top surface of the substrate 1) on which the semiconductor element 30 is formed.

Due to each of the K concentration and the Na concentration in the surface region of the substrate 1 being 5E15 cm⁻³ or less, the adhesion between the substrate 1 and the bottom electrode film 2 (or the bottom adhesive layer 6) can be improved. Thereby, even when an excessively large external force is repeatedly applied to the periphery of the bottom electrode film 2 during drive of the device 100 (the piezoelectric element 20), peeling of the bottom electrode film 2 and therefore the KNN film 3 from the substrate 1 can be prevented. As a result, reliability of the device 100 (piezoelectric element 20) can be improved.

The lower the K concentration and the Na concentration in the surface region of the substrate 1, the more the adhesion between the substrate 1 and the bottom electrode film 2 (or the bottom adhesive layer 6) can be improved. It is preferable that the K concentration and the Na concentration in the surface region of the substrate 1 are each 3E14 cm⁻³ or less. This enables to more improve the above-described adhesion. Further, it is more preferable that the K concentration in the surface region of the substrate 1 is, for example, 1E14 cm⁻³ or less. This enables to further improve the above-described adhesion.

The lower limits of the K concentration and the Na concentration in the surface region of the substrate 1 are not particularly limited. At present, according to SIMS analysis, the detection limit of the K concentration is about 1E14 cm⁻³, and the detection limit of the Na concentration is about 3E14 cm⁻³.

### (Feature 2)

When the KNN film 3 is deposited at a low temperature, the diffusion of the alkali metals to the substrate 1 and reaching the substrate 1 can be suppressed, but the (001) orientation rate of the KNN film 3 may decrease in some cases. As a result, the performance of the piezoelectric element 20 may be degraded.

To cope with such a problem, in this embodiment, the KNN film 3 is deposited under conditions of low temperature, high oxygen partial pressure, and low atmospheric pressure in the process of fabricating the device 100. That is, the deposition conditions for the KNN film 3 are not only low temperature but also high oxygen partial pressure and low atmospheric pressure. This enables to successfully obtain the KNN film 3 having a high (001) orientation rate (high crystal orientation) even when the KNN film 3 is deposited at a low temperature. This is a novel knowledge that was first found as a result of extensive research by the present inventors.

Specifically, the device 100 (stack 10) may have a feature (Feature 2) such that the (001) orientation rate of the KNN film 3 is, for example, 96 % or more, preferably 98 % or more.

Due to 96 % or more of the (001) orientation rate of the KNN film 3, the piezoelectric element 20 can have a high performance. Due to 98 % or more of the (001) orientation rate of the KNN film 3, the piezoelectric element 20 can have an even higher performance.

The (001) orientation rate of the KNN film 3 is the orientation rate of the crystals constituting the KNN film 3 in the (001) direction. "The (001) orientation rate of the KNN film 3 is 96 % or more" means that, for example, 96 % or more of the crystals constituting the KNN film 3 are oriented in the (001) direction with respect to the main surface of the substrate 1. The "orientation rate" in this specification is a value calculated from the following formula (1) based on the peak intensity in the X-ray diffraction pattern (2θ/θ) obtained by performing XRD measurement for the KNN film 3. Orientation rate (%) = {(001) peak intensity/((001) peak intensity+(110) peak intensity)}×100

The "(001) peak intensity" in the above formula (1) refers to, in the X-ray diffraction pattern obtained by performing XRD measurement for the KNN film 3, the intensity of a diffraction peak resulting from crystals oriented in the (001) direction (i.e., crystals whose (001) is parallel to the main surface of the substrate 1) among the crystals constituting the KNN film 3, which is the peak intensity appearing within the range of 20 of 20° to 23°, and which is the highest peak intensity when multiple peaks appear within the range of 20 of 20° to 23°. Also, the "(110) peak intensity" in the above formula (1) refers to, in the X-ray diffraction pattern obtained by performing XRD measurement for the KNN film 3, the intensity of a diffraction peak resulting from crystals oriented in the (110) direction (i.e., crystals whose (110) is parallel to the main surface of the substrate 1) among the crystals constituting the KNN film 3, which is the peak intensity appearing within the range of 20 of 30° to 33°, and which is the highest peak intensity when multiple peaks appear within the range of 20 of 30° to 33°.

In order to realize this feature, the KNN film 3 is required to have a perovskite structure. This is because, when the KNN film 3 does not have a perovskite structure, no peak can be observed within the range of 20 of at least 20° to 23° in the X-ray diffraction pattern obtained by performing the XRD measurement, and as a result, the (001) orientation rate cannot be calculated.

### (Feature 3)

In this embodiment, in the process of fabricating the device 100, the KNN film 3 is deposited under conditions of low temperature, high oxygen partial pressure, and low atmospheric pressure. This enables to successfully obtain the KNN film 3 having a high (001) orientation rate even when the film is deposited at a low temperature. As a result, the KNN film 3 with a high piezoelectric constant can also be obtained.

Specifically, the device 100 (stack 10) may have a feature (Feature 3) such that the absolute value of the piezoelectric constant e₃₁ of the KNN film 3 is, for example, 7 C/m² or more, preferably 10 C/m² or more.

Due to 7 C/m² or more of the absolute value of the piezoelectric constant e₃₁ of the KNN film 3, the piezoelectric element 20 can have a higher performance. Due to 10 C/m² or more of the absolute value of the piezoelectric constant e₃₁ of the KNN film 3, the piezoelectric element 20 can have an even higher performance.

### (2) Method for manufacturing a piezoelectric stack and a device having a piezoelectric element

A method for manufacturing the stack 10 and the device 100 described above will be described.

### (Preparation of the substrate)

First, a p-type Si substrate is prepared as the substrate 1. Further, a semiconductor element 30 having, for example, a CMOS structure is formed in advance on one of the two main surfaces of the substrate 1. Further, in the surface of the substrate 1 (the top surface of the substrate 1) on which the semiconductor element 30 is formed, a surface oxide film 1b is formed on the location except for the location where the semiconductor element 30 is formed. The semiconductor element 30 can be formed by various known techniques. Further, techniques such as a technique of thermally diffusing dopants and a technique of activating ions by ion implantation and annealing can be used for the formation of an n-type region (n-well 311, n-type source region 321, n-type drain region 322) and a p-type region (p-type source region 312, p-type drain region 313) of the semiconductor element 30. The CMOS structure formed using these techniques is vulnerable to heat. For example, when the n-type region or the p-type region is heated, the dopant may migrate, resulting in the change in the dopant concentration.

### (Deposition of the bottom adhesive layer and the bottom electrode film)

On the top surface (of the surface oxide film 1b) of the substrate 1, the bottom adhesive layer 6 (e.g., a ZnO layer) and the bottom electrode film 2 (e.g., a Pt film) are deposited in this order by, for example, a sputtering method. It is also acceptable to prepare the substrate 1 on which the bottom adhesive layer 6 and the bottom electrode film 2 are deposited in advance on the top surface of the substrate 1.

The conditions for depositing the ZnO layer as the bottom adhesive layer 6 are exemplified as follows. The deposition time for the bottom adhesive layer 6 is appropriately adjusted depending on the target thickness of the bottom adhesive layer 6.
Target: ZnO sintered ceramics
Temperature (substrate temperature): 200 °C or more and less than 500 °C, preferably 300 °C or more and 450 °C or less, more preferably 400 °C or more and 450 °C or less RF power density: 2 W/cm² or more and 6 W/cm² or less, preferably 3 W/cm² or more and 5 W/cm² or less
Atmosphere: an atmosphere of a mixed gas of argon (Ar) gas and oxygen (O₂) gas (hereinafter also referred to as "Ar/O₂ mixed gas atmosphere")
Ratio of partial pressure of Ar gas to O₂ gas (Ar gas partial pressure/O₂ gas partial pressure): 5/1 to 30/1, preferably 7/1 to 20/1, more preferably 10/1 to 15/1
Atmospheric pressure: 0.1 Pa or more and 0.5 Pa or less, preferably 0.2 Pa or more and 0.4 Pa or less
Thickness: 1 nm or more and 200 nm or less, preferably 10 nm or more and 50 nm or less

In this specification, when a numerical range is expressed, such as "5/1 to 30/1," it means that a lower limit value and an upper limit value are included in the range. The same applies to other numerical value ranges. Further, in this specification, the "substrate temperature" refers to the surface temperature of the substrate 1 during the deposition of each film (each layer).

The conditions for depositing the Ti layer, etc., as the bottom adhesive layer 6 are exemplified as follows.
Target: Ti plate, etc.
Temperature (substrate temperature): 100 °C or more and less than 500 °C, preferably 200 °C or more and 400 °C or less
Atmosphere: Ar gas atmosphere
Atmospheric pressure: 0.1 Pa or more and 0.5 Pa or less, preferably 0.2 Pa or more and 0.4 Pa or less

The other conditions can be similar to those used when providing the ZnO layer.

The conditions for depositing the Pt film as the bottom electrode film 2 are exemplified as follows. The deposition time for the bottom electrode film 2 is appropriately adjusted depending on the target thickness of the bottom electrode film 2.
Target: Pt plate
Temperature (substrate temperature): 200 °C or more and less than 500 °C, preferably 300 °C or more and 450 °C or less
RF power density: 1 W/cm² or more and 5 W/cm² or less, preferably 2 W/cm² or more and 4 W/cm² or less
Atmosphere: Ar gas atmosphere
Atmospheric pressure: 0.1 Pa or more and 0.5 Pa or less, preferably 0.2 Pa or more and 0.4 Pa or less
Thickness: 100 nm or more and 400 nm or less

By depositing the bottom adhesive layer 6 and the bottom electrode film 2 under the above-described conditions, particularly, by depositing the bottom adhesive layer 6 and the bottom electrode film 2 at a depositing temperature within a range of the above-described specified conditions, the thermal history of the semiconductor element 30 can be reduced. Thereby, shortening of the life span and degradation of the performance of the semiconductor element 30 can be suppressed.

### (Deposition of the KNN film)

After depositions of the bottom adhesive layer 6 and the bottom electrode film 2 are completed, the KNN film 3 is then deposited on the bottom electrode film 2 by a sputtering method such as RF magnetron sputtering. The composition of the KNN film 3 can be adjusted, for example, by controlling the composition of a target used during sputtering deposition. The target can be fabricated by mixing K₂CO₃ powder, Na₂CO₃ powder, Nb₂O₅ powder, etc., and sintering the mixture. The composition of the target can be controlled by adjusting the mixing ratio of K₂CO₃ powder, Na₂CO₃ powder, Nb₂O₅ powder, etc. When depositing the KNN film 3 containing the above-described elements such as Cu or Mn, the target obtained by mixing Cu powder (or CuO powder), Mn powder (or MnO powder), etc., in a predetermined ratio in addition to the above-described powders may be used.

In this embodiment, the deposition conditions for the KNN film 3 are a low temperature, a high oxygen partial pressure, and a low atmospheric pressure. Specifically, the conditions for depositing the KNN film 3 are exemplified as follows. The deposition time for the KNN film 3 is appropriately adjusted depending on the target thickness of the KNN film 3.
Temperature (substrate temperature): 400 °C or more and less than 500 °C, more preferably 400 °C or more and 450 °C or less
Atmosphere: Ar/O₂ mixed gas atmosphere
Oxygen partial pressure in the atmosphere (O₂ gas partial pressure): 0.0025 Pa or more and less than 0.01 Pa, preferably 0.003 Pa or more and less than 0.01 Pa
Atmospheric pressure (chamber pressure): 0.03 Pa or more and less than 0.1 Pa, preferably 0.03 Pa or more and less than 0.08 Pa
RF power density: 2.7 W/cm² or more and 4.1 W/cm² or less, preferably 2.8 W/cm² or more and 3.8 W/cm² or less
Deposition rate: 0.5 µm/hr or more and 4 µm/hr or less, preferably 0.5 µm/hr or more and 2 µm/hr or less
Thickness: 0.5 µm or more and 5 µm or less, preferably 1 µm or more and 3 µm or less

By depositing the KNN film 3 under the above-described conditions, particularly by depositing the KNN film 3 at a depositing temperature within the range of the above-described specified conditions, the thermal history of the semiconductor element 30 can be reduced. Thereby, for example, migration of dopants in the n-type region and p-type region of the semiconductor element 30 can be suppressed. As a result, shortening of the life span and degradation of the performance of the semiconductor element 30 can be suppressed. Further, the manufacturing yield of the device 100 can be increased.

Further, by depositing the KNN film 3 under the above-described conditions, particularly by depositing the KNN film 3 at a depositing temperature within the range of the above-described specified conditions, the diffusion of the alkali metals to the substrate 1 and reaching the substrate 1 can be suppressed. As a result, the K concentration and the Na concentration in the surface region of the substrate 1 can each be 5E15 cm⁻³ or less. That is, the stack 10 and therefore the device 100 having the above-described Feature 1 can be obtained.

Further, by depositing the KNN film 3 under the above-described conditions, particularly by depositing the KNN film 3 with the depositing temperature, oxygen partial pressure, and atmospheric pressure falling within the ranges of the above-described specified conditions, the (001) orientation rate of the KNN film 3 can be increased to 96 % or more. That is, the stack 10 and therefore the device 100 having the above-described Feature 2 can be obtained.

Further, enabling to increase the (001) orientation rate of the KNN film 3 to 96 % or more means that the absolute value of the piezoelectric constant e₃₁ of the KNN film 3 can be increased to 7 C/m² or more. That is, by depositing the KNN film 3 under the above-described conditions, particularly by depositing the KNN film 3 with the depositing temperature, oxygen partial pressure, and atmospheric pressure falling within the ranges of the above-described specified conditions, the absolute value of the piezoelectric constant e₃₁ of the KNN film 3 can be increased to 7 C/m² or more. As a result, the stack 10 and therefore the device 100 having the above-described Feature 3 can also be obtained.

When the depositing temperature of the KNN film 3 is 500 °C or more, the thermal history of the semiconductor element 30 cannot be reduced, and as a result, shortening of the life span and degradation of the performance of the semiconductor element 30 may not be suppressed. Further, when the depositing temperature of the KNN film 3 is 500 °C or more, the diffusion of the alkali metals to the substrate 1 and reaching the substrate 1 may not be suppressed.

Due to the depositing temperature of the KNN film 3 being less than 500 °C, the thermal history of the semiconductor element 30 can be reduced. Thereby, for example, migration of dopants in the n-type region and p-type region of the semiconductor element 30 can be suppressed. As a result, shortening of the life span and degradation of the performance of the semiconductor element 30 can be suppressed. Further, the manufacturing yield of the device 100 can be increased. Further, due to the depositing temperature of the KNN film 3 being less than 500 °C, the diffusion of the alkali metals can be suppressed, and the K concentration and the Na concentration each in the surface region of the substrate 1 can be reduced. As a result, the K concentration and the Na concentration in the surface region of the substrate 1 can each be reduced to 5E15 cm⁻³ or less.

Further, due to the depositing temperature of the KNN film 3 being, for example, 450 °C or less, the thermal history of the semiconductor element 30 can be further reduced. Further, the diffusion of the alkali metals can be reliably suppressed, and the K concentration and the Na concentration in the surface region of the substrate 1 can be further reduced. For example, the K concentration and the Na concentration in the surface region of the substrate 1 can each be 3E14 cm⁻³ or less, and further, the K concentration in the surface region of the substrate 1 can be 1E14 cm⁻³ or less.

When the depositing temperature of the KNN film 3 is, for example, less than 400 °C, the (001) orientation rate of the KNN film 3 may decrease, while saturating the effect of suppressing the diffusion of the alkali metals to the substrate 1 and reaching the substrate 1. As a result, even when the oxygen partial pressure and the atmospheric pressure during the deposition of the KNN film 3 are within the range of the specified conditions, the (001) orientation rate of the KNN film 3 may not be increased to 96 % or more. Therefore, the absolute value of the piezoelectric constant e₃₁ may not be increased to 7 C/m² or more. As a result of these, the performance of the piezoelectric element 20 may be degraded.

Due to the depositing temperature of the KNN film 3 being 400 °C or more, the (001) orientation rate of the KNN film 3 can be increased to 96 % or more and the absolute value of the piezoelectric constant e₃₁ can be increased to 7 C/m² or more, while suppressing the diffusion of alkali metals to the substrate 1 and reaching the substrate 1. As a result, the stack 10 and therefore the device 100 in which the semiconductor element 30 and the high-performance piezoelectric element 20 are formed on the same substrate 1, can be obtained.

Further, when the oxygen partial pressure during the deposition of the KNN film 3 is less than 0.0025 Pa, the (001) orientation rate of the KNN film 3 may not be increased sufficiently. That is, when the depositing temperature of the KNN film 3 is 400 °C or more and less than 500 °C and when the oxygen partial pressure is less than 0.0025 Pa, the (001) orientation rate of the KNN film 3 may not be increased to 96 % or more. Therefore, the absolute value of the piezoelectric constant e₃₁ may not be increased to 7 C/m² or more. As a result of these, the performance of the piezoelectric element 20 may be degraded.

Due to the oxygen partial pressure being 0.0025 Pa or more, the (001) orientation rate of the KNN film 3 can be sufficiently increased, and even when the depositing temperature of the KNN film 3 is 400 °C or more and less than 500 °C, the (001) orientation rate of the KNN film 3 can be increased to 96 % or more, and also the absolute value of the piezoelectric constant e₃₁ can be increased to 7 C/m² or more. As a result, the stack 10 and therefore the device 100 in which the semiconductor element 30 and the high-performance piezoelectric element 20 are formed on the same substrate 1, can be obtained. Due to the oxygen partial pressure being 0.003 Pa or more, the (001) orientation rate of the KNN film 3 can be further increased, and the (001) orientation rate of the KNN film 3 can be increased to 98 % or more, and also, the absolute value of the piezoelectric constant e₃₁ of the KNN film 3 can be increased to 10 C/m² or more. As a result, the stack 10 and therefore the device 100 in which the semiconductor element 30 and the higher performance piezoelectric element 20 are formed on the same substrate 1, can be obtained.

When the oxygen partial pressure is 0.01 Pa or more, the sputtering energy required for crystallization of the KNN film 3 is taken away by ionization of oxygen, and therefore the (001) orientation rate of the KNN film 3 is likely to decrease. Accordingly, when the depositing temperature is 400 °C or more and less than 500 °C and when the oxygen partial pressure is 0.01 Pa or more, the (001) orientation rate of the KNN film 3 may not be increased to 96 % or more. Therefore, the absolute value of the piezoelectric constant e₃₁ may not be increased to 7 C/m² or more. As a result of these, the performance of the piezoelectric element 20 may be degraded.

Due to the oxygen partial pressure being less than 0.01 Pa, the decrease in the (001) orientation rate of the KNN film 3 can be suppressed, and even when the depositing temperature of the KNN film 3 is 400 °C or more and less than 500 °C, the (001) orientation rate of the KNN film 3 can be increased to 96 % or more, and the absolute value of the piezoelectric constant e₃₁ of the KNN film 3 can be increased to 7 C/m² or more. As a result, the stack 10 and therefore the device 100 in which the semiconductor element 30 and the high-performance piezoelectric element 20 are formed on the same substrate 1, can be obtained.

Further, when the atmospheric pressure during the deposition of the KNN film 3 is 0.1 Pa or more, the (001) orientation rate of the KNN film 3 may not be increased sufficiently. Accordingly, when the depositing temperature of the KNN film 3 is 400 °C or more and less than 500 °C and when the atmospheric pressure is 0.1 Pa or more, the (001) orientation rate of the KNN film 3 may not be increased to 96 % or more. Therefore, the absolute value of the piezoelectric constant e₃₁ may not be increased to 7 C/m² or more. As a result of these, the performance of the piezoelectric element 20 may be degraded.

Due to the atmospheric pressure being less than 0.1 Pa, the (001) orientation rate of the KNN film 3 can be sufficiently increased, and even when the depositing temperature of the KNN film 3 is 400 °C or more and less than 500 °C, the (001) orientation rate of the KNN film 3 can be increased to 96 % or more, and the absolute value of the piezoelectric constant e₃₁ of the KNN film 3 can be increased to 7 C/m² or more. As a result, the stack 10 and therefore the device 100 in which the semiconductor element 30 and the high-performance piezoelectric element 20 are formed on the same substrate 1, can be obtained. Further, due to the atmospheric pressure being 0.08 Pa or less, the (001) orientation rate of the KNN film 3 can be further increased, and the (001) orientation rate of the KNN film 3 can be increased to 98 % or more, and the absolute value of the piezoelectric constant e₃₁ of the KNN film 3 can be increased to 10 c/m² or more. As a result, the stack 10 and therefore the device 100 in which the semiconductor element 30 and the higher performance piezoelectric element 20 are formed on the same substrate 1, can be obtained.

Further, when the atmospheric pressure is less than 0.03 Pa, the (001) orientation rate of the KNN film 3 may not be increased sufficiently. Accordingly, when the depositing temperature of the KNN film 3 is 400 °C or more and less than 500 °C and when the atmospheric pressure is less than 0.03 Pa, the (001) orientation rate of the KNN film 3 may not be increased to 96 % or more. Therefore, the absolute value of the piezoelectric constant e₃₁ may not be increased to 7 C/m² or more. As a result of these, the performance of the piezoelectric element 20 may be degraded.

Due to the atmospheric pressure being 0.03 Pa or more, the (001) orientation rate of the KNN film 3 can be sufficiently increased, and even when the depositing temperature of the KNN film 3 is 400 °C or more and less than 500 °C, the (001) orientation rate of the KNN film 3 can be increased to 96 % or more, and the absolute value of the piezoelectric constant e₃₁ of the KNN film 3 can be increased to 7 C/m² or more. As a result, the stack 10 and therefore the device 100 in which the semiconductor element 30 and the high-performance piezoelectric element 20 are formed on the same substrate 1, can be obtained.

As described above, only by depositing the KNN film 3 with the depositing temperature, oxygen partial pressure, and atmospheric pressure all falling within the ranges of the above-described specified conditions, the device 100 (stack 10) in which the semiconductor element 30 and the piezoelectric element 20 are formed on the same substrate 1 can be obtained while reducing the thermal history of the semiconductor element 30. Further, while reducing the thermal history of the semiconductor element 30, the device 100 (stack 10) having at least one of the above-described Features 1, 2, and 3, preferably all of the above-described Features 1, 2, and 3, can be obtained. That is, the stack 10 and therefore the device 100 in which the semiconductor element 30 and the high-performance piezoelectric element 20 are formed on the same substrate 1, can be obtained. If at least any of the conditions of the depositing temperature, oxygen partial pressure, and atmospheric pressure are outside the above ranges, it may not be possible to suppress shortening of the life span and performance degradation of the semiconductor element 30, and the performance of the piezoelectric element 20 may decrease. As a result, it may not be possible to obtain the stack 10 and therefore the device 100 in which the semiconductor element 30 and the piezoelectric element 20 are formed on the same substrate 1.

### (Deposition of the top adhesive layer and the top electrode film)

After the deposition of the KNN film 3 is completed, the top adhesive layer 7 (e.g., a RuO₂ layer) and the top electrode film 4 (e.g., a Pt film) are deposited in this order on the KNN film 3 by, for example, a sputtering method.

The conditions for depositing the RuO₂ layer, etc., as the top adhesive layer 7 are exemplified as follows. The deposition time for the top adhesive layer 7 is appropriately adjusted depending on the target thickness of the top adhesive layer 7.
Target: Ru plate, etc.
Temperature (substrate temperature): Room temperature (25 °C) or more and less than 500 °C, preferably room temperature (25 °C) or more and 450 °C or less RF power density: 0.3 W/cm² or more and 2 W/cm² or less, preferably 0.5 W/cm² or more and 1 W/cm² or less
Atmosphere: Ar/O₂ mixed gas atmosphere
Ratio of Ar gas partial pressure to O₂ gas (Ar gas partial pressure/O₂ gas partial pressure): 3/5 to 1/1, preferably 3/4 to 1/1
Atmospheric pressure: 0.1 Pa or more and 1.0 Pa or less, preferably 0.2 Pa or more and 0.7 Pa or less
Thickness: 1 nm or more and 200 nm or less, preferably 5 nm or more and 50 nm or less

The conditions for depositing the Pt film, etc., as the top electrode film 4 are exemplified as follows. The deposition time for the top electrode film 4 is appropriately adjusted depending on the target thickness of the top electrode film 4.
Target: The Pt plate, etc.
Temperature (substrate temperature): Room temperature (25 °C) or more and less than 500 °C, preferably room temperature (25 °C) or more and 450 °C or less RF power density: 1 W/cm² or more and 5 W/cm² or less, preferably 2 W/cm² or more and 4 W/cm² or less
Atmosphere: Ar gas atmosphere
Atmospheric pressure: 0.1 Pa or more and 0.5 Pa or less, preferably 0.2 Pa or more and 0.4 Pa or less
Thickness: 50 nm or more and 5000 nm or less, preferably 50 nm or more and 300 nm or less

By depositing the top adhesive layer 7 and the top electrode film 4 under the above-described conditions, particularly by depositing the top adhesive layer 7 and the top electrode film 4 at a depositing temperature within the range of the above-described specified conditions, the diffusion of the alkali metals into the substrate 1 can be more reliably suppressed while reducing the thermal history of the semiconductor element 30. As a result, the device 100 (stack 10) having at least one of the above-described Features 1, 2, and 3, preferably all of the above-described Features 1, 2, and 3, can be obtained while reducing the thermal history of the semiconductor element 30.

As described above, the bottom adhesive layer 6, the bottom electrode film 2, the KNN film 3, the top adhesive layer 7, and the top electrode film 4 are deposited in this order. Thereby, the stack 10 as shown in FIG. 2 can be obtained.

### (Formation of the piezoelectric element)

After the stack 10 as shown in FIG. 2 is fabricated, the stack 10 is processed to form a piezoelectric element 20 on the substrate 1.

Specifically, first, for example, the top electrode film 4 (including the top adhesive layer 7) and the KNN film 3 are individually patterned by dry etching using Ar gas or reactive gas. In the patterning, the top electrode film 4 (including the top adhesive layer 7) and the KNN film 3 are each formed into a predetermined shape, and a part of the bottom electrode film 2 is exposed. Further, in the patterning, a photoresist can be used as an etching mask.

After the patterning of the top electrode film 4 (including the top adhesive layer 7) and the KNN film 3 is completed, the bottom electrode film 2 and the bottom adhesive layer 6 are patterned by, for example, dry etching using Ar gas or reactive gas, and the bottom electrode film 2 and the bottom adhesive layer 6 are formed into predetermined shapes. In this patterning, a photoresist can be used as an etching mask.

After completing the patterning of the bottom electrode film 2 and the bottom adhesive layer 6, an insulating film 8 and metal wirings 9a and 9b are provided. Specifically, first, a layer composed of an insulating material (that is, the insulating film 8) is provided extending from the top electrode film 4 to the substrate 1 so as to cover the side surface of the KNN film 3 by a technique such as a CVD method or sputtering method. Then, the insulating film 8 is patterned by dry etching using Ar gas or reactive gas such as CF₄ gas, or wet etching, to form the insulating film 8 into a predetermined shape.

After the insulating film 8 is provided, a layer composed of a material containing metal (metal wiring layer) is provided by a technique such as a sputtering method, evaporation method, plating method, or metal paste method. Then, the metal wiring layer is patterned by dry etching using Ar gas or reactive gas, or wet etching, to thereby form metal wirings 9a and 9b. The metal wiring 9a is formed (patterned) so as to be connected to the bottom electrode film 2 and not connected to the top electrode film 4, and the metal wiring 9b is formed so as to be connected to the top electrode film 4 and not connected to the bottom electrode film.

The etching conditions for patterning when forming the insulating film 8 and the metal wirings 9a and 9b, and the etching conditions for the substrate 1 when processing the piezoelectric stack 10 into the piezoelectric element 20, can be general etching conditions used in a semiconductor device manufacturing process, as long as the insulation properties of the KNN film 3 are not deteriorated.

Further, a part of the substrate 1 is removed from the rear surface side of the substrate 1 by Deep-RIE or wet etching. Thereby, the piezoelectric element 20 is formed on the substrate 1. As a result, the device 100 in which the piezoelectric element 20 and the semiconductor element 30 are formed on the same substrate 1 as shown in FIG. 1, can be obtained.

### (3) Effect

According to this embodiment, one or more of the following effects can be obtained.
(a) In this embodiment, the KNN film 3 is deposited at a temperature of 400 °C or more and less than 500 °C in the process of fabricating the device 100. Thereby, the device 100 in which the semiconductor element 30 and the piezoelectric element 20 are formed on the same substrate 1, can be obtained while reducing the thermal history of the semiconductor element 30. Further, due to reducing the thermal history of the semiconductor element 30, shortening of the life span and degradation of the performance of the semiconductor element 30 can be suppressed. Further, the manufacturing yield of the device 100 can be increased.
(b) Further, by depositing the KNN film 3 under a temperature condition of 400 °C or more and less than 500 °C, the stack 10 and therefore the device 100, can have the feature (Feature 1) such that "the K concentration in the surface region of the substrate 1 is 5E15 cm⁻³ or less, and the Na concentration is 5E15 cm⁻³ or less." Due to the device 100 (stack 10) having the above-described Feature 1, the adhesion between the substrate 1 and the bottom electrode film 2 (bottom adhesive layer 6) can be improved. Thereby, during drive of the device 100 (piezoelectric element 20), even when excessive external force is repeatedly applied to the periphery (peripheral members) of the bottom electrode film 2 due to repeated large deformation of the KNN film 3, peeling of the bottom electrode film 2 and therefore the KNN film 3 from the substrate 1 can be avoided. As a result, the reliability of the device 100 can be improved.
(c) In this embodiment, in the process of fabricating the device 100, the KNN film 3 is deposited under conditions of a depositing temperature of 400 °C or more and less than 500 °C, an oxygen partial pressure of 0.0025 Pa or more and less than 0.01 Pa, and an atmospheric pressure of 0.03 Pa or more and less than 0.1 Pa. Thereby, even when the KNN film 3 is deposited at a low temperature of 400 °C or more and less than 500 °C, the (001) orientation rate of the KNN film 3 and the absolute value of the piezoelectric constant e₃₁ of the KNN film 3 deposited on the substrate 1 on which the semiconductor element 30 is formed, can be increased to 96 % or more and can be increased to 7 C/m² or more respectively. That is, the stack 10 and therefore the device 100, can have the feature (Feature 2) such that "the (001) orientation rate of the KNN film 3 is increased to 96 % or more." As a result, the stack 10 and therefore the device 100, can also have the feature (Feature 3) such that "the absolute value of the piezoelectric constant e₃₁ of the KNN film 3 is increased to 7 C/m² or more." When the device 100 (stack 10) has at least one of the above Features 2 and 3, the piezoelectric element 20 can have a high performance. Thus, in this embodiment, a high-performance piezoelectric element 20 can be formed on the substrate 1 on which the semiconductor element 30 is formed, while reducing the thermal history of the semiconductor element 30 (while suppressing performance degradation of the semiconductor element 30).
(d) By depositing the KNN film 3 with the depositing temperature, oxygen partial pressure, and atmospheric pressure all falling within the ranges of the above-described specified conditions, the stack 10 and therefore the device 100 having all of the above-described Features 1 to 3 can be obtained, while reducing the thermal history of the semiconductor element 30.

It has also been proposed to fabricate a piezoelectric stack using a bonding technique, that is a technique of depositing a first electrode film, a KNN film, and a second electrode film on a first substrate in this order, bonding a second substrate on which a semiconductor element 30 is previously formed, to the top surface of the second electrode film, and then, removing the first substrate, to thereby fabricate a piezoelectric stack. It is considered that in the piezoelectric stack fabricated by using such a bonding technique, the thermal history of the semiconductor element 30 is reduced, and alkali metals don't diffuse to the second substrate and don't reach the second substrate. In the piezoelectric stack fabricated by this technique, the second electrode film functions as a bottom electrode film, and the first electrode film functions as a top electrode film. However, the piezoelectric stack fabricated using such a bonding technique has a problem in that the adhesion between the substrate (second substrate) and the bottom electrode film (second electrode film) is very low. Further, in such a bonding technique, the number of steps required to fabricate the piezoelectric stack increases, which may lead to concerns about the complication of the fabrication process, reduced productivity, and increased cost. In contrast, according to this embodiment, the stack 10 in which the semiconductor element 30 and the piezoelectric element 20 are formed on the same substrate 1, is fabricated without using the bonding technique, and further, in the fabrication process, the diffusion of alkali metals to the substrate 1 and reaching the substrate 1 is suppressed while reducing the thermal history of the semiconductor element 30. Thereby, the adhesion between the substrate 1 and the bottom electrode film 2 (bottom adhesive layer 6) is successfully improved, while reducing the thermal history of the semiconductor element 30. Further, since the stack 10 is fabricated without using the bonding technique, the stack 10 (the piezoelectric element 20) according to this embodiment has no traces resulting from bonding. That is, in the stack 10 (the piezoelectric element 20) according to this embodiment, there are no traces of bonding at the interface between the substrate 1 and the KNN film 3, the interface between the substrate 1 and the bottom electrode film 2 (bottom adhesive layer 6, if present), or the interface between the bottom electrode film 2 and the KNN film 3. For example, the "traces resulting from bonding" are as follows: the presence (distribution) of inclusions (e.g., adhesive) used in bonding, and the presence (distribution) of impurities not resulting from the deposition process (e.g., impurities resulting from the adhesive).

### (4) Variations

This embodiment can be modified like the following variations. In the explanation for the variations, the same components as those in the above embodiment are denoted by the same reference numerals, and the description thereof will be omitted. The above embodiments and the following variations can be combined in any combination.

### (Variation 1)

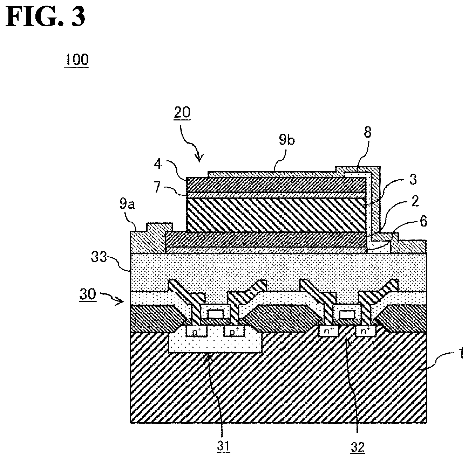

The above embodiment shows the case where the piezoelectric element 20 is formed at a location different from the location where the semiconductor element 30 is formed on the top surface of the substrate 1, but the present invention is not limited thereto. For example, as shown in FIG. 3, the piezoelectric element 20 may be formed on the semiconductor element 30. In this case, the "surface region of the substrate 1" is the region extending from the interface between the piezoelectric element 20 and the semiconductor element 30 (or protective film 33, if the protective film 33 is provided) to a depth of 1 µm toward the rear surface of substrate 1. Further, for example, the piezoelectric element 20 may be formed on the top surface of the substrate 1 such that a portion of the piezoelectric element 20 is located above the semiconductor element 30. In this case, the "surface region of the substrate 1" is the region extending from the interface between the piezoelectric element 20 and the semiconductor element 30 (protective film 33) or the substrate 1 to a depth of 1 µm toward the rear surface of the substrate 1.

In this variation also, in the process of fabricating the device 100, by depositing the KNN film 3 with the depositing temperature, oxygen partial pressure, and atmospheric pressure all falling within the ranges of the above-described specified conditions, the thermal history of the semiconductor element 30 can be reduced. As a result, in this variation also, the stack 10 and therefore the device 100 in which the semiconductor element 30 and the piezoelectric element 20 are formed on the same substrate 1, can be obtained. Further, in this variation also, the stack 10 and therefore the device 100, may have at least one of the above-described Features 1, 2, and 3. Thus, this variation also provides similar effects to those of the above embodiment.

### (Variation 2)

The above embodiment shows the case in which the substrate 1 is a p-type single crystal Si substrate 1a, that is, the substrate 1 is a p-type semiconductor substrate, but the present disclosure is not limited thereto. The substrate 1 may be an n-type semiconductor substrate. In this case, the p-type MOSFET 31 does not include the n-well 311, and the p-type source region 312 and the p-type drain region 313 are provided spaced apart from each other on the top surface of the substrate 1. Further, the n-type source region 321 and the n-type drain region 322 of the n-type MOSFET 32 are provided spaced apart from each other in a p-well formed on the top surface of the substrate 1. In this variation also, in the process of fabricating the device 100, by depositing the KNN film 3 with the depositing temperature, oxygen partial pressure, and atmospheric pressure all falling within the ranges of the above-described specified conditions, the thermal history of the semiconductor element 30 can be reduced. As a result, in this variation also, the stack 10 and therefore the device 100 in which the semiconductor element 30 and the piezoelectric element 20 are formed on the same substrate 1, can be obtained. Further, in this variation also, the stack 10 and therefore the device 100, may have at least one of the above-described Features 1, 2, and 3. Thus, this variation also provides similar effects to those of the above embodiment.

### (Variation 3)

The above-described embodiments and variations show the case in which the semiconductor element 30 has a CMOS structure. However, the semiconductor element 30 is not limited to CMOS, so long as it has an element structure that is vulnerable to heat. An element formed by using a technique of thermal diffusion or ion implantation of dopants to form the n-type or p-type region is vulnerable to heat. Accordingly, when the semiconductor element 30 is formed using these techniques, that is, when the semiconductor element 30 has a region in which the p-type or n-type dopants are thermally diffused or a region in which the dopants are ion-implanted, this embodiment can be suitably applied, and similar effects to the above-described embodiments and variations can be obtained.

### (Variation 4)

The above-described embodiments and variations show the case in which the substrate on which the semiconductor element 30 is formed, is used as the substrate 1. However, the present disclosure is not limited thereto.

As described above, since the KNN film 3 is deposited at a low temperature of 400 °C or more and less than 500 °C, other substrate for which a small thermal history is required, can be used as the substrate 1. For example, as the substrate 1, the substrate on which a CMUT (Capacitive Micro-machined Ultrasound Transducer) structure is formed can be used. Further, either a resin substrate or a glass substrate which is vulnerable to heat, can also be used as the substrate 1. Even when such a substrate is used as the substrate 1, in the process of fabricating the device 100, by depositing the KNN film 3 with the depositing temperature, oxygen partial pressure, and atmospheric pressure all falling within the range of the above-described specified conditions, a high-performance piezoelectric element 20 can be formed on the substrate 1 that is required to have a small thermal history or on the substrate 1 that is vulnerable to heat. Also in this variation, the stack 10 and therefore the device 100 can have at least one of the above-described Features 1, 2, and 3.

Further, an SOI (Silicon On Insulator) substrate or a quartz glass (SiO₂) substrate can also be used as the substrate 1. In this case also, the stack 10 and therefore the device 100 may have at least one of the above-described Features 1, 2, and 3.

### (Variation 5)

The above-described embodiments and variations show the case in which the bottom adhesive layer 6 and the bottom electrode film 2 are provided, but the present disclosure is not limited thereto. The bottom adhesive layer 6 and the bottom electrode film 2 may not be provided. That is, the KNN film 3 may be deposited directly on the substrate 1. In this variation, the piezoelectric element 20 is configured to include at least the KNN film 3 and the top electrode film 4 (including the top adhesive layer 7). Further, in this variation also, since the KNN film 3 is deposited at a low temperature of 400 °C or more and less than 500 °C, the substrate 1 can be any of the substrates described in the above-described variations 1 to 4.

In this variation also, in the process of fabricating the device 100, by depositing the KNN film 3 with the depositing temperature, oxygen partial pressure, and atmospheric pressure all falling within the ranges of the above-described specified conditions, the semiconductor element 30 and the piezoelectric element 20 can be formed on the same substrate 1. Further, in this variation also, the stack 10 and therefore the device 100 may have at least one of the above-described Features 1, 2, and 3. Thus, in this variation also, similar effects to those of the above-described embodiment can be obtained.

### <Other embodiments>

As described above, the embodiments and variations of the present disclosure have been explained in detail. However, the present disclosure is not limited to the above-described embodiments and variations, and various modifications are possible without departing from the spirit and scope of the present disclosure.

Further, the above-described embodiment shows the case in which the bottom adhesive layer 6 is provided between the substrate 1 and the bottom electrode film 2, and the top adhesive layer 7 is provided between the KNN film 3 and the top electrode film 4, but the present disclosure is not limited thereto. The bottom adhesive layer 6 and the top adhesive layer 7 do not need to be provided as long as necessary adhesion can be ensured.

### <Preferable embodiments of the present disclosure>

Preferable embodiments of the present disclosure will be supplementarily described below.

### (Supplementary description 1)

According to one aspect of the present disclosure, there is provided a device including:
a semiconductor element; and
a piezoelectric element having a piezoelectric film composed of alkali niobium oxide containing potassium, sodium, niobium, and oxygen,
wherein the semiconductor element and the piezoelectric element are formed on the same substrate.

### (Supplementary description 2)

Preferably, SIMS analysis for a region extending from an interface between the piezoelectric element and the semiconductor element or the substrate to a depth of 1 µm toward a surface opposite to a surface of the substrate on which the piezoelectric element is formed, reveals that a concentration of potassium is 5E15 cm⁻³ or less, and a concentration of sodium is 5E15 cm⁻³ or less.

### (Supplementary description 3)

Preferably, an orientation rate of crystals constituting the piezoelectric film in a (001) direction is 96 % or more.

### (Supplementary description 4)

Preferably, the piezoelectric film has a piezoelectric constant e₃₁ of 7 C/m² or more.

### (Supplementary description 5)

Preferably, the semiconductor element has a CMOS structure.

### (Supplementary description 6)

Preferably, the piezoelectric element is controlled by the semiconductor element.

### (Supplementary description 7)

Preferably, the piezoelectric element functions as an actuator, and an operation of the piezoelectric element is controlled by the semiconductor element.

### (Supplementary description 8)

Preferably, the piezoelectric element functions as a sensor, and a signal detected by the piezoelectric element is processed by the semiconductor element.

### (Supplementary description 9)

Preferably, the piezoelectric element functions as a sensor, and an operation of the piezoelectric element is controlled by the semiconductor element.

### (Supplementary description 10)

Preferably, the piezoelectric element functions as an energy harvester, and the semiconductor element is operated by an electrical energy generated by the piezoelectric element.

### (Supplementary description 11)

Preferably, the semiconductor element has a region into which a p-type or n-type dopant has been thermally diffused, or a region into which the dopant has been ion-implanted.

### (Supplementary description 12)

According to another aspect of the present disclosure, there is provided a stacked substrate including:
a semiconductor element; and
a piezoelectric element having a piezoelectric film composed of alkali niobium oxide containing potassium, sodium, niobium, and oxygen,
wherein the semiconductor element and the piezoelectric element are formed on the same substrate.

### (Supplementary description 13)

There is provided the device according to any one of supplementary descriptions 1 to 11 or the stacked substrate according to supplementary description 12, wherein preferably there are no traces of bonding at an interface between the substrate and the piezoelectric film, an interface between the substrate and the bottom electrode film (or a bottom adhesive layer if the bottom adhesive layer is included), or an interface between the bottom electrode film and the piezoelectric film. The traces resulting from bonding refer to a distribution of inclusions used in bonding, a distribution of impurities not resulting from a deposition process, and the like.

### (Supplementary description 14)

According to further another aspect of the present disclosure, there is provided a method for manufacturing a device, the method including:
preparing a substrate on which a semiconductor element is formed; and
forming a piezoelectric element on the substrate,
wherein the forming the piezoelectric element includes depositing a piezoelectric film composed of alkali niobium oxide containing potassium, sodium, niobium, and oxygen on the substrate under conditions of a depositing temperature of less than 500 °C, an oxygen partial pressure of 0.0025 Pa or more and less than 0.01 Pa, and an atmospheric pressure of 0.03 Pa or more and less than 0.1 Pa.

### Description of signs and numerals

1. Substrate
2. Bottom electrode film
3. Piezoelectric film
4. Top electrode film
6. Bottom adhesive layer
7. Top adhesive layer
8. Insulating film
9a, 9b. Metal wiring
10. Stack
20. Piezoelectric element
30. Semiconductor element
100. Device (having a piezoelectric film)

## Claims

1. A device comprising:
a semiconductor element; and
a piezoelectric element having a piezoelectric film composed of alkali niobium oxide containing potassium, sodium, niobium, and oxygen,
wherein the semiconductor element and the piezoelectric element are formed on the same substrate.

2. The device according to claim 1, wherein SIMS analysis for a region extending from an interface between the piezoelectric element and the semiconductor element or the substrate to a depth of 1 µm toward a surface opposite to a surface of the substrate on which the piezoelectric element is formed, reveals that a concentration of potassium is 5E15 cm⁻³ or less, and a concentration of sodium is 5E15 cm⁻³ or less.

3. The device according to claim 1 or 2, wherein an orientation rate of crystals constituting the piezoelectric film in a (001) direction is 96 % or more.

4. The device according to claim 1 or 2, wherein the piezoelectric film has a piezoelectric constant e₃₁ of 7 C/m² or more.

5. The device according to claim 1 or 2, wherein the semiconductor element has a CMOS structure.

6. The device according to claim 1 or 2, wherein the piezoelectric element is controlled by the semiconductor element.

7. The device according to claim 1 or 2, wherein the piezoelectric element functions as an actuator, and an operation of the piezoelectric element is controlled by the semiconductor element.

8. The device according to claim 1 or 2, wherein the piezoelectric element functions as a sensor, and a signal detected by the piezoelectric element is processed by the semiconductor element.

9. The device according to claim 1 or 2, wherein the piezoelectric element functions as a sensor, and an operation of the piezoelectric element is controlled by the semiconductor element.

10. The device according to claim 1 or 2, wherein the piezoelectric element functions as an energy harvester, and the semiconductor element is operated by an electrical energy generated by the piezoelectric element.

11. The device according to claim 1 or 2, wherein the semiconductor element has a region into which a p-type or n-type dopant has been thermally diffused, or a region into which the dopant has been ion-implanted.

12. A method for manufacturing a device, comprising:
preparing a substrate on which a semiconductor element is formed; and
forming a piezoelectric element on the substrate,
wherein the forming the piezoelectric element includes depositing a piezoelectric film composed of alkali niobium oxide containing potassium, sodium, niobium, and oxygen on the substrate under conditions of a depositing temperature of 400 °C or more and less than 500 °C, an oxygen partial pressure of 0.0025 Pa or more and less than 0.01 Pa, and an atmospheric pressure of 0.03 Pa or more and less than 0.1 Pa.
